# EUROPEAN PATENT SPECIFICATION

(11) **EP 4 241 157 B1**
(45) Date of publication and mention of the grant of the patent: **13.05.2026**
(21) Application number: 21890225.2
(22) Date of filing: 08.11.2021
(51) Int. Cl.: G06F 3/01, C09K 11/02, C09K 11/58, D01F 1/10, D01F 6/76, D01F 8/16, D01F 8/18, D02G 3/32, D02G 3/44, H02N 2/18, H10N 30/30, H10N 30/60, H10N 30/00, H10N 30/85, H10N 30/857

(54) **MECHANO-LUMINESCENT-OPTOELECTRONIC SMART CLOTHING**
MECHANOLUMINESZENTE UND OPTOELEKTRONISCHE INTELLIGENTE BEKLEIDUNG
VÊTEMENT INTELLIGENT MÉCANO-LUMINESCENT-OPTOÉLECTRONIQUE

(30) Priority: 09.11.2020 US 202063111132 P
(43) Date of publication of application: 13.09.2023
(73) Proprietor: New Mexico Tech University Research Park Corporation, Socorro, NM 87801 (US)
(72) Inventor: RYU, Donghyeon, Socorro, NM 87801 (US)
(74) Representative: Avidity IP
(86) International application number: PCT/US2021/058422
(87) International publication number: WO 2022/099116

(56) References cited:
- WO-A2-2019/173375
- WO-A2-2019/173375
- US-A1- 2009 027 872
- US-A1- 2009 085 444
- US-A1- 2016 354 502
- US-A1- 2017 369 776
- US-B1- 9 610 476
- PULLIAM ELIAS ET AL: "Development of self-powered strain sensor using mechano-luminescent ZnS:Cu and mechano-optoelectronic P3HT", PROCEEDINGS OF SPIE; [PROCEEDINGS OF SPIE ISSN 0277-786X VOLUME 10524], SPIE, US, vol. 10168, 12 April 2017 (2017-04-12), pages 101680G - 101680G, XP060091229, ISBN: 978-1-5106-1533-5, DOI: 10.1117/12.2260318

## Description

### CROSS REFERENCE

This application claims the benefit of U.S. Provisional Application No. 63/111,132, filed November 9, 2020.

### BACKGROUND

Smart clothing can be used to help people prevent heart failure, manage diabetes, measure health parameters, and improve overall quality of life. Smart clothing has been limited to sensors embedded into garments to obtain data. The prior art document WO2019/73375 discloses a mechano-luminescent elastomeric substrate which is a ZnS: Cu/polydimethyl-siloxane composite, being used in strain sensors.

### SUMMARY OF THE INVENTION

In some embodiments, disclosed herein is a structure comprising: a) a filamentous core, wherein the filamentous core comprises an elastomeric material; and b) a coating surrounding the filamentous core, wherein the coating comprises a mechano-optoelectronic material, wherein the structure is a thread.

In some embodiments, disclosed herein is a fabric comprising a structure, the structure comprising: a) a filamentous core, wherein the filamentous core comprises an elastomeric material; and b) a coating surrounding the filamentous core, wherein the coating comprises a mechano-optoelectronic material, wherein the structure is a thread.

In some embodiments, disclosed herein is a system comprising a structure of the disclosure or a fabric of the disclosure. In some embodiments, disclosed herein is a method of harvesting energy, the method comprising collecting the direct current electricity produced by a structure, fabric, or system of the disclosure.

### BRIEF DESCRIPTION OF THE DRAWINGS

**FIG. 1A** shows an MLO thread comprising a mechano-luminescent copper-doped zinc sulfide-embedded elastomeric composite (101) and a mechano-optoelectronic composite film coating (102). **FIG. 1B** shows a fabric that is weaved using an MLO material or a thread of the disclosure (black) and a secondary fiber (white).
**FIG. 2** shows the device set up used to test a sheet material comprising the MLO materials of the disclosure.
**FIG. 3A** shows changes in normalized voltage and strain with time. **FIG. 3B** shows mean maximum voltage in relation to strain (%). **FIG. 3C** shows changes in mean maximum voltage in relation to frequency (Hz).
**FIG. 4** shows a shirt comprising the MLO materials of the disclosure.

### DETAILED DESCRIPTION OF THE INVENTION

Lead zirconate titanate (Pb[Zr(x)Ti(1-x)]O₃ or PZT) is useful for sensing applications. PZT is brittle and can break under excessive pressure or deformation. Piezoelectric materials produce high voltages, but the output currents are relatively low, resulting in low total electric output. Mechanical-electrical energy conversion of piezoelectric materials also require mechanical vibrations in a narrow frequency range. This requirement makes the use of piezoelectric sensor modules in wearable applications challenging.

Mechano-luminescence-optoelectronic (MLO) materials can serve as self-powering sensor platforms, with other sensing modalities encoded by adding additional physics-responsive materials. Further, the platform size and shape can be customized to a wide range of applications. MLO materials comprise highly flexible materials and perform well when deformed, for example, in wearable applications. MLO materials can have scaled electric output by adjusting the active areas, and DC output can be increased with input mechanical strain/rate magnitudes. Further, the range of active loading frequency of MLO materials is wider and lower to fit the frequency of loadings experienced by wearable applications.

Disclosed herein are self-powered and multi-modal sensing wearables (SMSW). In some embodiments, the SMSW comprise MLO materials for self-powered sensing and energy harvesting. The MLO devices used herein can be, for example, light weight, minimally intrusive, small in size, highly flexible, resilient, and/or self-powering. In some embodiments, the multi-modal sensing signals around human bodies can provide information that benefits a user's wellness.

In some embodiments, disclosed herein is a structure comprising: a) a filamentous core, wherein the filamentous core comprises an elastomeric material; and b) a coating surrounding the filamentous core, wherein the coating comprises a mechano-optoelectronic material, wherein the structure is a thread. In some embodiments, disclosed herein is a fabric comprising a structure, the structure comprising: a) a filamentous core, wherein the filamentous core comprises an elastomeric material; and b) a coating surrounding the filamentous core, wherein the coating comprises a mechano-optoelectronic material, wherein the structure is a thread. In some embodiments, further disclosed herein is a method of harvesting energy, the method comprising collecting the direct current electricity produced by a structure of the disclosure or a fabric of the disclosure.

### Mechano-optoelectronic materials

In some embodiments, a wearable material of the disclosure can utilize the properties of mechano-optoelectronic materials. In some embodiments, disclosed herein is a structure comprising: a) a filamentous core, wherein the filamentous core comprises an elastomeric material; and b) a coating surrounding the filamentous core, wherein the coating comprises a mechano-optoelectronic material, wherein the structure is a thread. In some embodiments, the mechano-optoelectronic material is a mechano-luminescent-optoelectronic composite. In some embodiments, the mechano-optoelectronic composite is a film. In some embodiments, the mechano-optoelectronic material is a poly(3-hexylthiophene) film.

In some embodiments, the mechano-optoelectronic material is P3HT. P3HT is a long chain polymer consisting of thiophene monomers with alkyl groups attached at location 3 of the thiophene ring. P3HT exhibits unique optoelectronic properties due to electrons being transferred along the backbone of the long chain polymer (i.e., intramolecular electron transfer) and between neighboring molecules (i.e., intermolecular electron transfer).

P3HT can act as an electron donor (i.e., p-type semiconductor). The movement of electrons across P3HT is attributed to the existence of loosely bound electrons (i.e., delocalized electrons) in the sp² orbital of the thiophene ring. The electron donating ability of P3HT and the intrinsic mechanical flexibility of P3HT makes P3HT a promising candidate for use in flexible electronics. In some embodiments, P3HT can be used in applications such as biomedical sensing, renewable energy, field-effect transistors, and SHM sensors. In some embodiments, P3HT can be used in chemoresistive sensors, piezoresistive sensors, electrical sensors, and optoelectronic sensors.

P3HT-based threads of the disclosure can exhibit multifunctional performance capabilities and can possess mechano-optoelectronic (MO) properties. In some embodiments, the P3HT-based threads can comprise an n-type semiconductor. In some embodiments, the n-type semiconductor comprises phosphorous. In some embodiments, the n-type semiconductor comprises arsenic. In some embodiments, the n-type semiconductor comprises antimony. In some embodiments, the n-type semiconductor is a phenyl-C₆₁-butyric acid methyl ester (PCBM)-based n-type semiconductor. In some embodiments, P3HT-based threads can be used for self-powered strain sensing. In some embodiments, P3HT-based threads can be used to harvest energy. In some embodiments, P3HT-based threads can generate direct current (DC) under light, and the generated DC can vary in magnitude with tensile strain. The strain-sensitive DC generated from a P3HT-based threads result from: 1) the MO properties of the P3HT-based threads resulting from P3HT crystalline structures; and 2) optical property changes of the P3HT-based threads when the thread is subjected to macro-scale mechanical deformation (i.e., tensile strain). Variations in light absorption of P3HT-based threads can modulate the generated DC.

In some embodiments, the mechano-optoelectronic material is a poly(alkyl-thiophene). In some embodiments, the mechano-optoelectronic material is poly(3-alkyl-thiophene). In some embodiments, the poly(3-hexylthiophene) film is a poly(3-hexylthiophene):phenyl-C61-butyric acid methyl ester film. In some embodiments, the poly(3-hexylthiophene):phenyl-C61-butyric acid methyl ester film comprises a 1:1 weight ratio of poly(3-hexylthiophene) to phenyl-C61-butyric acid methyl ester. In some embodiments, the poly(3-hexylthiophene) film is doped with carbon nanotubes. In some embodiments, the mechano-optoelectronic material produces a direct current in response to a mechanical force that is exerted on the thread.

### Elastic-mechano-luminescent ZnS:Cu

Mechano-luminescence (ML) is a particular type of luminescence, which defines the transformative material property that converts mechanical energy to photonic energy. ML can be classified into two categories: tribo-ML (TML) and deformation-ML (DML). TML exhibits photonic energy emissions due to tribological contacts between two different materials. DML does not involve two different materials in light emission. DML generates light when DML materials are deformed by externally applied mechanical energy. DML generates light regardless of the type of material used to apply mechanical energy. Depending on the extent of deformation at which photonic energy generation is triggered (i.e., threshold deformation for light emission), DML materials are categorized into three different types of DML: fracto-ML, elastic-ML, and plastic-ML.

Unlike fracto-ML (FML) crystals, elastic-ML (EML) crystals are capable of converting mechanical energy to photonic energy without cleavage of the crystalline structures. Among EML materials, wideband gap II-VI semiconducting compounds have high ML yield rates. Zinc sulfide (ZnS) exhibits a particularly high ML yield ratio (i.e., ratio between light intensity and material mass), which is comparable to the ML yield ratio of europium dibenzoylmethide triethylammonium. Europium dibenzoylmethide triethylammonium is a FML crystal that emits a bright amount of light. When ZnS is doped with copper, the Cu-doped ZnS:Cu crystals can exhibit increased capabilities compared to ZnS crystals.

Crystalline lattices are dislocated by elastic and/or plastic deformations, and the dislocations create an electrostatic potential difference between charged dislocations and defects, which are filled with electrons. As the number of dislocations increase, electrons trapped in the defects are transferred to the conduction band through the electrostatic potential gradient attributed to energy band bending by overcoming energy barriers. The transferred electrons are recombined with the holes, resulting in light emission.

ML light emission profiles including, for example, the intensity and color of ML light, of ZnS:Cu composites can be affected by strain, strain rate, and ZnS:Cu doping concentrations. ML properties of ZnS:Cu composites can be studied under various strain loadings. The ML responses of ZnS:Cu composites resulting from fatigue loading and impact can be measured using, for example, a photoluminescent spectrophotometer, photodiodes, and high-speed camera. In some embodiments, a technology of the disclosure can utilize the ML properties of materials such as, for example, ZnS or ZnS:Cu.

In some embodiments, the structures, fabrics, and systems of the disclosure can comprise a filamentous core, wherein the filamentous core comprises an elastomeric material. In some embodiments, the elastomeric material is an elastomeric composite. In some embodiments, the elastomeric material is a copper-doped zinc sulfide (ZnS:Cu)-based elastomeric composite.

### Assembly of MO and ML materials.

In some embodiments, the present disclosure describes the assembly of transformative ML and MO materials. In some embodiments, an assembly of transformative ML and MO materials does not require an external electrical input. In some embodiments, mechanical energy generated from dynamic behaviors of structures such as, for example, wearable garments can be harvested. In some embodiments, mechanical energy from vibrations of structures such as, for example, wearable garments, can be harvested via coupling of two energy conversion mechanisms, such as, mechanical-radiant and radiant-electrical energy conversions. MLO composite materials are materials that can produce electric current when exposed to a mechanical force due to the coupling of ML and MO properties. When a mechanical force such as, for example, strain, is applied to a MLO composite material the mechanical force causes luminescence to be released from the ML portion of the material. The released luminescence is absorbed by the MO portion of the material which results in the production of direct current. In some embodiments, materials are functionalized and designs are optimized to improve the robustness and performance of MLO composite materials.

### Development of multifunctional MLO composites

In some aspects, the present disclosure describes the design of a multifunctional MLO composite using two-dimensional building blocks. Two-dimensional building blocks can be, for example: 1) a ML substrate such as, for example, ZnS or ZnS:Cu crystals; and 2) a MO film such as, for example a MO conjugated P3HT polymer composition. The designed MLO composites can be fabricated by assembling: 1) a ML substrate such as, for example, ZnS:Cu-embedded elastomeric composites, which emit light in response to mechanical stimuli, with 2) a MO thread such as, for example, P3HT-based sensing thread, which generate DC by absorbing photonic energy (i.e., ML light).

In some embodiments, a conductive layer, such as, for example a poly(3,4ethylenedioxythiophene):polystyrene sulfonate (PEDOT:PSS) layer, is placed between the ML substrate and MO film. In some embodiments, one or both of the ML substrate and MO film is in contact with the conductive layer. In some embodiments, one or both of the ML substrate and MO film is attached to the conductive layer. In some embodiments, an air gap or a vacuum is located between the conductive layer and one or both of the ML substrate and MO film. In some embodiments, one or both of the ML substrate and MO film is adjacent to the conducting layer. In some embodiments, one or both of the ML substrate and MO film is not adjacent to the conductive layer. In some embodiments, the ML substrate, MO film and conductive layer are all held together into a single unit. In some embodiments, the ML substrate, MO film, and conductive layer are held together by compression. In some embodiments, the ML substrate, MO film and conductive layer are encased in a polymer such as, for example PDMS. In some embodiments, a transparent or translucent material separates one or both of the ML substrate or MO film from the conductive layer. In some embodiments, different transparent or translucent materials separate the ML substrate and MO film from the conductive layer. In some embodiments, ML substrate is a fiber, and the outer surface of the ML substrate is in contact with the MO films are coated on.

In some embodiments, the ML substrate, MO film and conductive layer are arranged in layers. The layers can be for example parallel layers, about parallel layers, or deviated from parallel layers. In some embodiments each layer is in contact with at least one other layer. Layers can be separated by, for example, an air gap, a vacuum, a solid, a liquid, or a gas.

In some embodiments, the MLO devices of the disclosure can comprise gallium indium (EGaIn). In some embodiments, the MLO devices of the disclosure can comprise PCBM. In some embodiments, the MLO devices of the disclosure can comprise P3HT. In some embodiments, the MLO devices of the disclosure can comprise PDMS. In some embodiments, the MLO devices of the disclosure can comprise PEDOT:PSS.

In some embodiments, ML ZnS:Cu based elastomeric composites can be produced by dispersing ZnS:Cu powder particles in an elastomer matrix to form a ZnS:Cu/PDMS elastomer. In some embodiments the elastomer matrix is a polydimethylsiloxane (PDMS) elastomer matrix. The amount of ZnS:Cu powder present in composites can be, for example, about 5% (w/w) to about 95% (w/w). The amount of ZnS:Cu powder present in composites can be, for example, about 5% (w/w) to about 10% (w/w), about 5% (w/w) to about 20% (w/w), about 5% (w/w) to about 30% (w/w), about 5% (w/w) to about 40% (w/w), about 5% (w/w) to about 50% (w/w), about 5% (w/w) to about 60% (w/w), about 5% (w/w) to about 70% (w/w), about 5% (w/w) to about 80% (w/w), about 5% (w/w) to about 90% (w/w), about 5% (w/w) to about 95% (w/w), about 10% (w/w) to about 20% (w/w), about 10% (w/w) to about 30% (w/w), about 10% (w/w) to about 40% (w/w), about 10% (w/w) to about 50% (w/w), about 10% (w/w) to about 60% (w/w), about 10% (w/w) to about 70% (w/w), about 10% (w/w) to about 80% (w/w), about 10% (w/w) to about 90% (w/w), about 10% (w/w) to about 95% (w/w), about 20% (w/w) to about 30% (w/w), about 20% (w/w) to about 40% (w/w), about 20% (w/w) to about 50% (w/w), about 20% (w/w) to about 60% (w/w), about 20% (w/w) to about 70% (w/w), about 20% (w/w) to about 80% (w/w), about 20% (w/w) to about 90% (w/w), about 20% (w/w) to about 95% (w/w), about 30% (w/w) to about 40% (w/w), about 30% (w/w) to about 50% (w/w), about 30% (w/w) to about 60% (w/w), about 30% (w/w) to about 70% (w/w), about 30% (w/w) to about 80% (w/w), about 30% (w/w) to about 90% (w/w), about 30% (w/w) to about 95% (w/w), about 40% (w/w) to about 50% (w/w), about 40% (w/w) to about 60% (w/w), about 40% (w/w) to about 70% (w/w), about 40% (w/w) to about 80% (w/w), about 40% (w/w) to about 90% (w/w), about 40% (w/w) to about 95% (w/w), about 50% (w/w) to about 60% (w/w), about 50% (w/w) to about 70% (w/w), about 50% (w/w) to about 80% (w/w), about 50% (w/w) to about 90% (w/w), about 50% (w/w) to about 95% (w/w), about 60% (w/w) to about 70% (w/w), about 60% (w/w) to about 80% (w/w), about 60% (w/w) to about 90% (w/w), about 60% (w/w) to about 95% (w/w), about 70% (w/w) to about 80% (w/w), about 70% (w/w) to about 90% (w/w), about 70% (w/w) to about 95% (w/w), about 80% (w/w) to about 90% (w/w), about 80% (w/w) to about 95% (w/w), or about 90% (w/w) to about 95% (w/w). The amount of ZnS:Cu powder present in composites can be, for example, about 5% (w/w), about 10% (w/w), about 20% (w/w), about 30% (w/w), about 40% (w/w), about 50% (w/w), about 60% (w/w), about 70% (w/w), about 80% (w/w), about 90% (w/w), or about 95% (w/w). The amount of ZnS:Cu powder present in composites can be, for example, at least about 5% (w/w), at least about 10% (w/w), at least about 20% (w/w), at least about 30% (w/w), at least about 40% (w/w), at least about 50% (w/w), at least about 60% (w/w), at least about 70% (w/w), at least about 80% (w/w), or at least about 90% (w/w). The amount of ZnS:Cu powder present in composites can be, for example, at most about 10% (w/w), at most about 20% (w/w), at most about 30% (w/w), at most about 40% (w/w), at most about 50% (w/w), at most about 60% (w/w), at most about 70% (w/w), at most about 80% (w/w), at most about 90% (w/w), or at most about 95% (w/w).

In some embodiments, P3HT-based sensing materials can be fabricated by doping P3HT with carbon nanotubes or blending p-type P3HT and n-type phenyl-C61-butyric acid methyl ester (PCBM). Non-limiting examples of substrates include thermally deposited or electrically-sputtered aluminum, glass, elastomers, and PDMS elastomers. In some embodiments, the MLO threads of the disclosure can comprise 1, 2, 3, 4, 5, 6, 7, 8, 9, or 10 layers of material. In some embodiments the MLO thread is a PEDOT:PSS thread. In some embodiments, the MLO threads of the disclosure comprise 1, 2, 3, 4, 5, 6, 7, 8, 9, or 10 layers of PEDOT:PSS.

P3HT-based sensing structures or threads comprising P3HT or P3HT:PCBM can be fabricated on a substrate, for example, a PDMS elastomer. In some embodiments the PDMS elastomer is a ZnS:Cu/PDMS composite. In some instances the PDMS elastomer can be pre-strained. The PDMS elastomer can be pre-strained, for example, to about 1% to about 50%. The PDMS elastomer can be pre-strained, for example, to about 1% to about 5%, about 1% to about 10%, about 1% to about 15%, about 1% to about 20%, about 1% to about 25%, about 1% to about 30%, about 1% to about 35%, about 1% to about 40%, about 1% to about 45%, about 1% to about 50%, about 5% to about 10%, about 5% to about 15%, about 5% to about 20%, about 5% to about 25%, about 5% to about 30%, about 5% to about 35%, about 5% to about 40%, about 5% to about 45%, about 5% to about 50%, about 10% to about 15%, about 10% to about 20%, about 10% to about 25%, about 10% to about 30%, about 10% to about 35%, about 10% to about 40%, about 10% to about 45%, about 10% to about 50%, about 15% to about 20%, about 15% to about 25%, about 15% to about 30%, about 15% to about 35%, about 15% to about 40%, about 15% to about 45%, about 15% to about 50%, about 20% to about 25%, about 20% to about 30%, about 20% to about 35%, about 20% to about 40%, about 20% to about 45%, about 20% to about 50%, about 25% to about 30%, about 25% to about 35%, about 25% to about 40%, about 25% to about 45%, about 25% to about 50%, about 30% to about 35%, about 30% to about 40%, about 30% to about 45%, about 30% to about 50%, about 35% to about 40%, about 35% to about 45%, about 35% to about 50%, about 40% to about 45%, about 40% to about 50%, or about 45% to about 50%. The PDMS elastomer can be pre-strained, for example, to about 1%, about 5%, about 10%, about 15%, about 20%, about 25%, about 30%, about 35%, about 40%, about 45%, or about 50%. The PDMS elastomer can be pre-strained, for example, to at least about 1%, about 5%, about 10%, about 15%, about 20%, about 25%, about 30%, about 35%, about 40%, or about 45%. The PDMS elastomer can be pre-strained, for example, to at most about 5%, about 10%, about 15%, about 20%, about 25%, about 30%, about 35%, about 40%, about 45%, or about 50%.

MLO multifunctional composites can be designed using a bottom-up nanotechnology and factorial design methodology. Target functionalities that the MLO multifunctional composites are required to exhibit can be established. Functional building blocks such as, for example, ZnS:Cu and P3HT used to tune the transformative properties of the functional building blocks for acquiring the target functionalities can be designed. In some embodiments, the transformative properties of the functional building blocks are the ML and MO of the materials. The functional building blocks can be assembled to harness the unique transformative properties at a macro-scale. The transformative MO and ML properties of the two functional building blocks can be coupled to achieve target functionalities.

In some embodiments, P3HT and ZnS:Cu can be used as functional building blocks. To design the functional building blocks to achieve desired luminescent and optoelectronic properties under various types of loadings, the ML properties of ZnS:Cu, and the MO properties of P3HT can be analyzed. The MO property of P3HT is affected by regioregularity and microstructures of P3HT molecules. The piezo-optical properties of P3HT are attributed to the improved microstructures of P3HT under applied strain.

The effect of mechanical and thermal strain on changes in microstructures, and the optoelectronic properties of P3HT can be studied using techniques including, for example, X-ray diffraction and an atomic force microscopy (AFM). Grazing incidence (GI) diffraction and small angle X-ray scattering (SAXs) can be used to characterize the 3-dimensional crystalline structure of P3HT.

ZnS:Cu composite and P3HT-based building blocks can be assembled up to a meso-scale using fabrication techniques. In some embodiments, a mechano-luminescent core is fabricated, and a mechano-optoelectronic thin film is coated onto the surface of the mechano-luminescent core. In some embodiments, a mechano-luminescent core can be extruded into a thread form. In some embodiments, the mechano-optoelectronic coating can be administered using air-brushing. In some embodiments, the mechano-optoelectronic coating can be administered using ink-jet printing methods. In some embodiments, an electrode is placed: 1) between the mechano-luminescent core and the mechano-optoelectronic coating; and 2) on top of the mechano-optoelectronic coating to collect direct current. Non-limiting examples structures on which the P3HT-based sensing structures of threads and ZnS:Cu-based elastomeric composites can be fabricated on, for example, polyimide threads or PEDOT:PSS threads.

A MLO composite of the disclosure can exhibit multifunctional capabilities including, for example, self-powered sensing and energy harvesting, by coupling the ML of ZnS:Cu and the MO of P3HT. A strained ZnS:Cu-based functional layer can emit light, which is supplied through a film such as, for example, a polyimide or PEDOT:PSS film, to the P3HT-based sensing thin film to generate DC. In some embodiments, the magnitude of the generated DC varies with the applied strain; strain-sensitive DC can be used as the sensor signal. Multimodal sensing capabilities can be encoded by dying and/or functionalizing P3HT-based thin films to tune light absorption wavelengths such that frequency changes can be recorded. The color of ML light from ZnS:Cu can vary with loading frequency. A composite of the disclosure can exhibit energy harvesting capabilities from the generated DC.

In some embodiments, a MLO composite of the disclosure can produce a voltage change in response to strain as low as about 30%, as low as about 25%, as low as about 20%, as low as about 15%, as low as about 10%, as low as about 5%, as low as about 4%, as low as about 3%, as low as about 2%, or as low as about 1%. In some embodiments, a MLO composite of the disclosure can produce a voltage change in response to a loading frequency as low as about 1 Hz, as low as about 2 Hz, as low as about 3 Hz, as low as about 4 Hz, as low as about 5 Hz, as low as about 10 Hz, as low as about 15 Hz, as low as about 20 Hz, as low as about 25 Hz, as low as about 30 Hz, as low as about 35 Hz, as low as about 40 Hz, as low as about 45 Hz, as low as about 50 Hz, as low as about 55 Hz, as low as about 60 Hz, as low as about 65 Hz, as low as about 70 Hz, as low as about 75 Hz, as low as about 80 Hz, as low as about 85 Hz, as low as about 90 Hz, as low as about 95 Hz, as low as about 100 Hz, as low as about 150 Hz, as low as about 200 Hz, as low as about 250 Hz, as low as about 300 Hz, as low as about 350 Hz, as low as about 400 Hz, as low as about 450 Hz, as low as about 500 Hz, as low as about 550 Hz, as low as about 600 Hz, as low as about 650 Hz, as low as about 700 Hz, as low as about 750 Hz, as low as about 800 Hz, as low as about 850 Hz, as low as about 900 Hz, as low as about 950 Hz, or as low as about 1000 Hz.

Design optimization is performed to attain desired functionalities, such as high strain sensitivity, frequency-sensitive multi-band vibration sensing, multi-modal sensing, and high PCE. In some embodiments, the frequency-sensitive multi-band vibration sensing is used to sense dynamic vibrations. In some embodiments, the multi-modal sensing is used to sense physical phenomena, for example, mechanical strain, pH, or temperature. After assembly of the two functional building blocks, self-powered and multimodal sensing and energy harvesting can be assessed through experimental and theoretical studies. Computational and experimental studies can be conducted to investigate the effective modulus, hardness, stress-strain characteristics, and damage evolution as influenced by the material and geometric layout. A TriboIndenter^{®} can be used to assess the mechanical resiliency of the MLO composites.

In some embodiments, the MLO composite comprises a material exhibiting a mechanical-radiant energy conversion. In some embodiments, the MLO composite comprises a radiant-electrical energy converter material. In some embodiments, the MLO composite comprises a mechanical-radiant material and a radiant-electrical energy converter material. In some embodiments, the MLO composite comprises a material with mechano-optoelectronic properties. In some embodiments, the MLO composite comprises a material with strain-sensitive optoelectronic properties. In some embodiments, the MLO composite comprises a material with mechano-luminescent properties. In some embodiments, the MLO composite comprises a first material with a mechano-optoelectronic property and a second material with a mechano-luminescent properties.

In some embodiments, the MLO composite comprises a material that can provide current-based sensing. In some embodiments, the MLO composite comprises a material that can provide voltage-based sensing. In some embodiments, the MLO composite comprises a material that can provide direct current (DC)-based sensing. In some embodiments, the MLO composite comprises a material that can provide mechanical-radiant electrical energy conversion. In some embodiments, the MLO composite comprises a material that can provide current-based sensing and mechanical-radiant electrical energy conversion. In some embodiments, the MLO composite comprises a material that can provide DC-based sensing and mechanical-radiant electrical energy conversion.

### Smart clothing MLOs

The MLO smart clothing of the disclosure are composed of two functional materials: 1) conjugated poly(3-hexylthiophene) (P3HT)-based self-sensing thin film; and 2) mechano-luminescent (ML) copper-doped zinc sulfide (ZnS:Cu)-based elastomeric composites core material. In some embodiments, the MLO smart clothing of the disclosure are fabricated as a thread with a ZnS:Cu-based composite core, which is coated with P3HT-based thin films along with electrode layers for DC collection. When the MLO experiences external mechanical stimuli, the ML component glows to source light to P3HT-based thin films to produce direct current (DC). The DC output from MLO can show strain-sensitivity by showing varying DC magnitude with varying amounts of strain.

In some embodiments, the structures disclosed herein can further comprise a fiber layer surrounding the structure (i.e., thread). In some embodiments, the fiber layer comprises a natural fiber. In some embodiments, the fiber layer comprises a synthetic fiber. In some embodiments, the fiber layer comprises cotton. In some embodiments, the fiber layer comprises polyester. In some embodiments, the fiber layer comprises rayon. In some embodiments, the fiber layer comprises nylon.

In some embodiments, a structure of the disclosure can be twisted with a filament. In some embodiments, the structure and the filament are twisted with an S-twist. In some embodiments, the structure and the filament are twisted with a Z-twist.

In some embodiments, the structure further comprises an embedded electrode. In some embodiments, the embedded electrode collects a direct current.

The MLO smart clothing disclosed herein can measure strains on body surfaces where the smart clothes are worn. The measured strains are processed to yield data that exhibit features sensitive to parameters used. In some embodiments, the measured strains are processed to track human motion. In some embodiments, the measured strains are processed to measure vital signs.

In some embodiments, the MLO component of the smart clothing can convert mechanical energy from body movement to produce electrical energy. In some embodiments, electrical energy generated from the MLO smart clothing can be used for various applications, for example, lighting, charging batteries, or charging mobile devices.

In some embodiments, the MLO smart clothing of the disclosure can use multi-modal sensing technology. In some embodiments, the multi-modal sensing technology can detect changes in strain, pH, or temperature of the user. In some embodiments, the multi-modal sensing technology can use an electrocardiogram (ECG) to measure vital signs and individual anaerobic thresholds. In some embodiments, the multi-modal sensing technology can detect fitness training, sleep management information, and 3-dimensional (3D) muscle tracking.

The MLO devices of the disclosure can be used for 3D muscle tracking wearable (3D-MTW) technology. In some embodiments, 3D-MTW provides real-time multi-modal sensor information. In some embodiments, 3D-MTW can be used to address pain points. In some embodiments, 3D-MTW can be used to determine energy-dependency.

In some embodiments, the multi-modal sensing technology can detect 3D muscle tracking. In some embodiments, an algorithm is used to calculate muscle shape using strain information at different locations with known coordinate information. In some embodiments, an algorithm is used to calculate muscle volume change using strain information at different locations with known coordinate information. In some embodiments, an algorithm is used to calculate muscle shape and muscle volume change using strain information at different locations with known coordinate information. In some embodiments, a 3D map of a subject's body is produced using strain changes at designated locations, for example, sensor node locations. In some embodiments, 3D mapping comprises obtaining baseline body volume data of the subject. In some embodiments, muscle measurements are made before an activity (e.g., weight lifting) and after the activity to determine changes in one of the subject's muscles. In some embodiments, muscle measurements are made before an activity (e.g., weight lifting) and after the activity to determine changes in a plurality of the subject's muscles. In some embodiments, an activity changes strain values at one sensor node location. In some embodiments, an activity changes strain values at a plurality of sensor node locations. In some embodiments, the algorithm requires designation of at least one sensor node to create a boundary, wherein a muscle belongs to a designated boundary.

In some embodiments, the MLO devices of the disclosure can be used to detect anomalies in human motion, for example, walking patterns and angles relevant for posture. In some embodiments, human motion anomaly data can be used to prevent injury in the subject. In some embodiments, the MLO devices of the disclosure can be used to create virtual reality avatars, wherein the avatar copies a subject's motion. In some embodiments, the MLO devices of the disclosure can be used to diagnose a physiological condition. In some embodiments, the MLO devices of the disclosure can be used to diagnose a mental condition. In some embodiments, the MLO devices of the disclosure can be integrated with a haptic system as a sensor component to form a closed loop with actuator, for use in games and simulations.

In some embodiments, the MLO devices of the disclosure can use bioelectrical impedance analysis (BIA) to gain information about muscle growth. In some embodiments, electromyography (EMG) can be used to provide quantitative and objective data on muscle load, muscle balance, or muscle ratio in a user. In some embodiments, EMG-based wearables can rely on an external energy source.

In some embodiments, the MLO threads of the disclosure can have a diameter of less than about 5 mm, less than about 4.5 mm, less than about 4 mm, less than about 3.5 mm, less than about 3 mm, less than about 2.5 mm, less than about 2 mm, less than about 1.8 mm, less than about 1.6 mm, less than about 1.4 mm, less than about 1.2 mm, less than about 1 mm, less than about 0.9 mm, less than about 0.8 mm, less than about 0.7 mm, less than about 0.6 mm, less than about 0.5 mm, less than about 0.4 mm, less than about 0.3 mm, less than about 0.2 mm, less than or about 0.1 mm. In some embodiments, the MLO threads of the disclosure can have a diameter of less than about 2 mm. In some embodiments, the MLO threads of the disclosure can have a diameter of less than about 1 mm. In some embodiments, the MLO threads of the disclosure can have a diameter of less than about 0.5 mm.

In some embodiments, the MLO threads of the disclosure can have a diameter of about 5 mm, about 4.5 mm, about 4 mm, about 3.5 mm, about 3 mm, about 2.5 mm, about 2 mm, about 1.8 mm, about 1.6 mm, about 1.4 mm, about 1.2 mm, about 1 mm, about 0.9 mm, about 0.8 mm, about 0.7 mm, about 0.6 mm, about 0.5 mm, about 0.4 mm, about 0.3 mm, about 0.2 mm, or about 0.1 mm. In some embodiments, the MLO threads of the disclosure can have a diameter of about 2 mm. In some embodiments, the MLO threads of the disclosure can have a diameter of about 1 mm. In some embodiments, the MLO threads of the disclosure can have a diameter of about 0.5 mm.

In some embodiments, the MLO threads of the disclosure comprise PDMS. In some embodiments, the MLO threads of the disclosure exhibit elasticity of at least about 5%, at least about 10%, at least about 15%, at least about 20%, at least about 25%, at least about 30%, at least about 35%, at least about 40%, at least about 45%, at least about 50%, at least about 55%, at least about 60%, at least about 65%, at least about 70%, at least about 75%, at least about 80%, at least about 85%, at least about 90%, at least about 95%, at least or about 100%. In some embodiments, the MLO threads of the disclosure exhibit elasticity of at least about 20%. In some embodiments, the MLO threads of the disclosure exhibit elasticity of at least about 60%. In some embodiments, the MLO threads of the disclosure exhibit elasticity of at least about 80%. In some embodiments, the MLO threads of the disclosure exhibit elasticity of at least about 90%. In some embodiments, the MLO threads of the disclosure exhibit elasticity of at least about 95%. In some embodiments, the MLO threads of the disclosure exhibit elasticity of at least about 100%.

In some embodiments, each MLO thread can have an electrical connector to output DC as an electrical energy source. In some embodiments, each MLO thread can have an electrical connector to strain sensing signals. In some embodiments, each MLO thread can comprise a data acquisition system (DAQ) or an external rechargeable battery where the MLO electrodes are connected. In some embodiments, sensor signals from the MLO threads can be collected via approximate wireless communication units, for example, Bluetooth technology. In some embodiments, a wireless communication unit can connect to an entire MLO smart thread sensor network and communicate data to a device for data collection and processing. In some embodiments, the device is a smart phone.

In some embodiments, disclosed herein is a structure comprising: a) a filamentous core, wherein the filamentous core comprises an elastomeric material; and b) a coating surrounding the filamentous core, wherein the coating comprises a mechano-optoelectronic material, wherein the structure is a thread.

In some embodiments, disclosed herein is a fabric comprising a structure, the structure comprising: a) a filamentous core, wherein the filamentous core comprises an elastomeric material; and b) a coating surrounding the filamentous core, wherein the coating comprises a mechano-optoelectronic material, wherein the structure is a thread.

In some embodiments, the MLO smart threads of the disclosure can be integrated into a foundational fabric comprising a conventional fiber material. In some embodiments, an additional layer made of a conventional fiber material can be placed around the MLO smart thread. In some embodiments, the additional layer can conceal the MLO smart thread. In some embodiments, the additional layer can protect the MLO smart thread from wear-and-tear. In some embodiments, the electrostatic effects between the MLO smart thread and the foundational fabric material are considered when preparing an MLO smart clothing garment of the disclosure.

In some embodiments, the MLO smart threads can be woven into a fabric material. In some embodiments, a hybrid smart thread can be created by layering the MLO smart thread with a conventional fabric material.

In some embodiments, a fabric can comprise at most about 10%, at most about 15%, at most about 20%, at most about 25%, at most about 30%, at most about 35%, at most about 40%, at most about 45%, at most about 50%, at most about 55%, at most about 60%, at most about 65%, at most about 70%, at most about 75%, at most about 80%, at most about 85%, at most about 90%, at most or about 95% of the MLO threads of the disclosure. In some embodiments, a fabric can comprise at most about 20% of the MLO threads of the disclosure. In some embodiments, a fabric can comprise at most about 30% of the MLO threads of the disclosure. In some embodiments, a fabric can comprise at most about 50% of the MLO threads of the disclosure.

In some embodiments, a fabric of the disclosure can be from about 0.1 mm to about 0.5 mm thick. In some embodiments, a fabric of the disclosure can be from about 0.1 mm to about 0.2 mm, from about 0.2 mm to about 0.3 mm, from about 0.3 mm to about 0.4 mm, or from about 0.4 mm to about 0.5 mm thick. In some embodiments, a fabric of the disclosure can be about 0.1 mm, about 0.15 mm, about 0.2 mm, about 0.25 mm, about 0.3 mm, about 0.35 mm, about 0.4 mm, about 0.45 mm, or about 0.5 mm thick. In some embodiments, a fabric of the disclosure can be about 0.2 mm thick. In some embodiments, a fabric of the disclosure can be about 0.3 mm thick. In some embodiments, a fabric of the disclosure can be about 0.4 mm thick.

In some embodiments, the fabric is water-resistant. In some embodiments, the fabric is waterproof.

In some embodiments, the MLO smart fabric of the disclosure can be woven into clothing to manufacture the MLO smart clothes. In some embodiments, the MLO smart fabric of the disclosure can be used in fiber-reinforced polymer (FRP) composites or patches. In some embodiments, the MLO threads of the disclosure can be woven into a shirt. In some embodiments, the MLO threads of the disclosure can be woven into pants. In some embodiments, the MLO threads of the disclosure can be woven into gloves. In some embodiments, the MLO threads of the disclosure can be woven into socks. In some embodiments, the MLO threads of the disclosure can be used in a wrist band, watch strap, face covering, head covering, belt, or hat.

### EXAMPLES

### EXAMPLE 1: Method for testing strain v. direct current (DC)

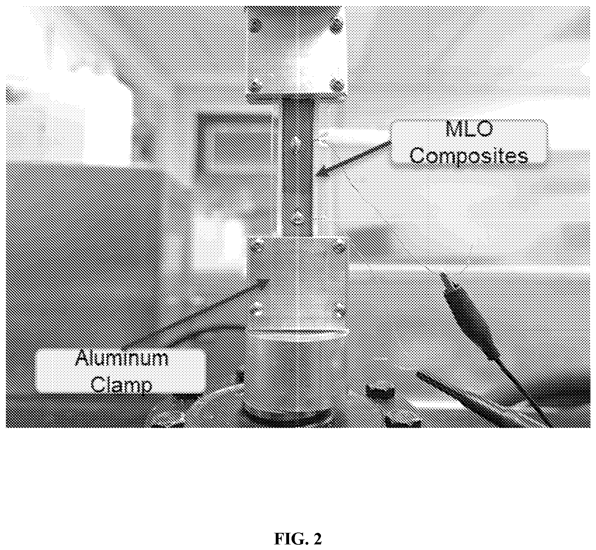

Cyclic tensile loadings were applied using a load frame. Four sets of sinusoidal cyclic tensile loadings were applied by varying maximum strain. Maximum strain in the sets was 3%, 5%, 8%, and 10%. In each set of loading, loading frequency was varied from 1-15 Hz in 4 steps with a time period of 7 seconds. Testing was conducted in a dark room to minimize ambient lighting effects. **FIG. 2** shows the device set up used to test a sheet comprising the MLO materials of the disclosure. Uniaxial tensile loading was applied to the MLO sheet specimen, which was wired to measure DC voltage output. **TABLE 1** shows the testing step, time range, and loading frequency used in each testing step.

**TABLE 1**

| **Testing step** | **Time range (sec)** | **Loading frequency (Hz)** |
|---|---|---|
| 1 | 0-7 | 1 |
| 2 | 10-17 | 5 |
| 3 | 21-27 | 10 |
| 4 | 31-37 | 15 |

Maximum DC voltage (DCV) varied with the magnitude of strain and strain rate. Light was emitted from the ML ZnS Cu material when strain was applied. The light emitted shined on a photoactive P3HT:PCBM thin film. Straining of P3HT aligned the molecules, which increased charge carrier mobility. The data showed that P3HT:PCBM thin films converted light energy to electrical energy.

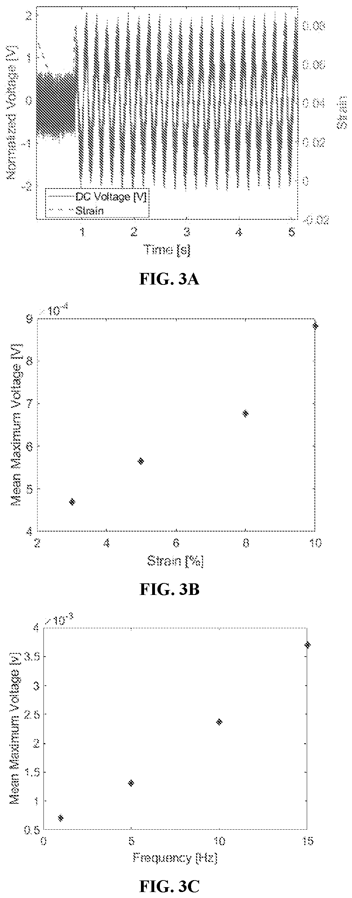

**FIG. 3A** shows changes in normalized voltage and strain with time. Output DCV was normalized with DCV at 0% strain and is shown with applied strain. **FIG. 3B** shows mean maximum voltage in relation to strain (%). Mean max DCV was calculated for cases at 10 Hz frequency and shown with applied max strain. **FIG. 3C** shows changes in mean maximum voltage in relation to frequency (Hz). Mean max DCV was calculated for test cases at 10% max strain and is shown with applied max strain.

### EXAMPLE 2: Mechano-luminescence-optoelectronic threads and fabrics

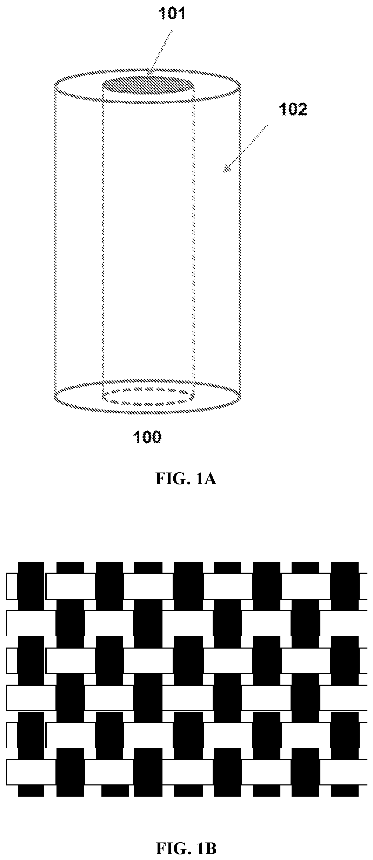

A MLO material of the disclosure is prepared in the form of a thread or long cylindrical structure. **FIG. 1A** shows an MLO thread comprising a copper-doped zinc sulfide-embedded elastomeric composite (101) and a mechano-luminescence-optoelectronic composite film coating (102)

An MLO material of the disclosure is prepared in the form of a thread or long cylindrical structure. The MLO material can be used alone or as a thread, for example, twisted with a filament as described above. The MLO material is then weaved with a secondary fiber to form a fabric. **FIG. 1B** shows a fabric that is weaved using an MLO material or a thread of the disclosure (black) and a secondary fiber (white).

### EXAMPLE 3: Mechano-luminescence-optoelectronic smart clothing

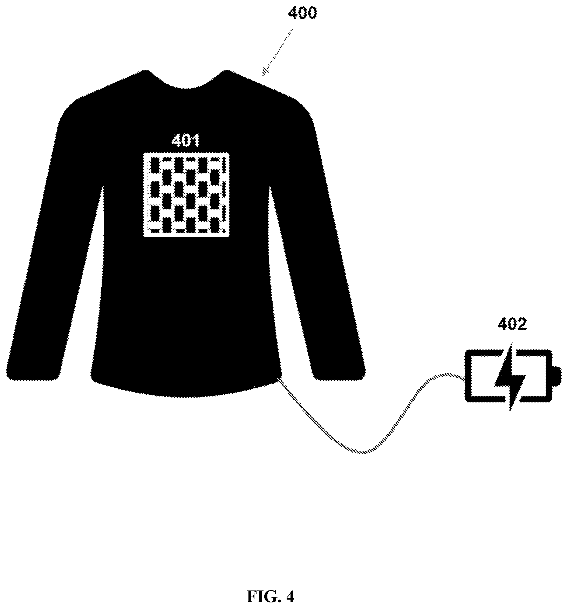

A fabric patch of **EXAMPLE 3** is incorporated into a clothing garment, for example, a shirt. The shirt is also connected to an external battery. **FIG. 4** shows a shirt comprising a patch made of the MLO materials of the disclosure. The shirt (400) comprises a patch (401) made of an MLO material or fabric of the disclosure. The shirt (400) can further comprise a storage battery (402) to harvest energy produced by the patch (401).

## Claims

1. A structure comprising:
a) a filamentous core, wherein the filamentous core comprises an elastomeric material; and
b) a coating surrounding the filamentous core, wherein the coating comprises a mechano-optoelectronic material,
wherein the structure is a thread.

2. The structure of claim 1, wherein the thread has a mean diameter of less than about 2 mm, optionally wherein the thread has a mean diameter of less than about 1 mm.

3. The structure of claim 1 or 2, wherein the elastomeric material is an elastomeric composite.

4. The structure of any one of claims 1-3, wherein the elastomeric material is a copper-doped zinc sulfide (ZnS:Cu)-based elastomeric composite.

5. The structure of claim 4, wherein the ZnS:Cu-based elastomeric composite is a ZnS:Cu/polydimethylsiloxane composite, optionally wherein the ZnS:Cu/polydimethylsiloxane composite contains from about 5% to about 70% ZnS:Cu by mass.

6. The structure of any one of claims 1-5, wherein the mechano-optoelectronic material is a mechano-luminescent-optoelectronic composite.

7. The structure of any one of claims 1-6, wherein the mechano-optoelectronic material is a film.

8. The structure of any one of claims 1-7, wherein the mechano-optoelectronic material is a poly(3-hexylthiophene) film.

9. The structure of claim 8, wherein the poly(3-hexylthiophene) film is a poly(3-hexylthiophene):phenyl-C61-butyric acid methyl ester film, optionally wherein the poly(3-hexylthiophene):phenyl-C61-butyric acid methyl ester film comprises a 1:1 mass ratio of poly(3-hexylthiophene) to phenyl-C61-butyric acid methyl ester.

10. The structure of claim 8, wherein the poly(3-hexylthiophene) film is doped with carbon nanotubes.

11. The structure of any one of claims 1-10, wherein the mechano-optoelectronic material produces a direct current in response to a mechanical force that is exerted on the thread, optionally wherein the mechanical force is a vibrational force or a strain.

12. The structure of any one of claims 1-11, further comprising a fiber layer surrounding the structure, optionally wherein the fiber layer comprises a natural fiber, a synthetic fiber, cotton, polyester, rayon, or nylon.

13. The structure of any one of claims 1-12, wherein the structure is twisted with a filament, optionally wherein the structure and the filament are twisted with an S-twist or a Z-twist.

14. The structure of any one of claims 1-13, wherein the structure further comprises an electrode embedded in the structure, optionally wherein the electrode collects a direct current.

15. The structure of any one of claims 1-14, wherein the thread has an elasticity of at least about 80%, optionally wherein the thread has an elasticity of at least about 95%.

## Patentansprüche

1. Struktur, umfassend:
a) einen filamentösen Kern, wobei der filamentöse Kern ein elastomeres Material umfasst; und
b) eine Beschichtung, die den filamentösen Kern umgibt, wobei die Beschichtung ein mechano-optoelektronisches Material umfasst,
wobei die Struktur ein Faden ist.

2. Struktur nach Anspruch 1, wobei der Faden einen mittleren Durchmesser von weniger als etwa 2 mm aufweist, optional wobei der Faden einen mittleren Durchmesser von weniger als etwa 1 mm aufweist.

3. Struktur nach Anspruch 1 oder 2, wobei das elastomere Material ein Elastomerverbundstoff ist.

4. Struktur nach einem der Ansprüche 1 bis 3, wobei das elastomere Material ein Elastomerverbundstoff auf Basis von kupferdotiertem Zinksulfid (ZnS:Cu) ist.

5. Struktur nach Anspruch 4, wobei der Elastomerverbundstoff auf ZnS:Cu-Basis ein ZnS:Cu/Polydimethylsiloxan-Verbundstoff ist, optional wobei der ZnS:Cu/Polydimethylsiloxan-Verbundstoff von etwa 5% bis etwa 70% ZnS:Cu Masseanteil enthält.

6. Struktur nach einem der Ansprüche 1 bis 5, wobei das mechano-optoelektronische Material ein mechano-lumineszentes-Optoelektronik-Komposit ist.

7. Struktur nach einem der Ansprüche 1 bis 6, wobei das mechano-optoelektronische Material ein Film ist.

8. Struktur nach einem der Ansprüche 1 bis 7, wobei das mechano-optoelektronische Material ein Poly(3-hexylthiophen)-Film ist.

9. Struktur nach Anspruch 8, wobei der Poly(3-hexylthiophen)-Film ein Poly(3-hexylthiophen):phenyl-C61-Buttersäuremethylester-Film ist, optional wobei der Poly(3-hexylthiophen):phenyl-C61-Buttersäuremethylester-Film gegebenenfalls ein Massenverhältnis von 1:1 von Poly(3-hexylthiophen) zu Phenyl-C61-Buttersäuremethylester umfasst.

10. Struktur nach Anspruch 8, wobei der Poly(3-hexylthiophen)-Film mit Kohlenstoffnanoröhren dotiert ist.

11. Struktur nach einem der Ansprüche 1 bis 10, wobei das mechano-optoelektronische Material einen direkten Strom als Reaktion auf eine mechanische Kraft erzeugt, die auf den Faden ausgeübt wird, optional wobei die mechanische Kraft eine Vibrationskraft oder eine Dehnbeanspruchung ist.

12. Struktur nach einem der Ansprüche 1 bis 11, ferner umfassend eine Faserschicht, die die Struktur umgibt, optional wobei die Faserschicht eine Naturfaser, eine synthetische Faser, Baumwolle, Polyester, Rayon oder Nylon umfasst.

13. Struktur nach einem der Ansprüche 1 bis 12, wobei die Struktur mit einem Filament verdrillt ist, optional wobei die Struktur und das Filament mit einem S-Schlag oder einem Z-Schlag verdrillt sind.

14. Struktur nach einem der Ansprüche 1 bis 13, wobei die Struktur ferner eine Elektrode umfasst, die in die Struktur eingebettet ist, optional wobei die Elektrode einen Gleichstrom aufnimmt.

15. Struktur nach einem der Ansprüche 1 bis 14, wobei der Faden eine Elastizität von mindestens etwa 80% aufweist, optional wobei der Faden eine Elastizität von mindestens etwa 95% aufweist.

## Revendications

1. Structure comprenant :
a) un noyau filamenteux, dans laquelle le noyau filamenteux comprend un matériau élastomère ; et
b) un revêtement entourant le noyau filamenteux, dans laquelle le revêtement comprend un matériau mécano-optoélectronique,
dans laquelle la structure est un fil.

2. Structure selon la revendication 1, dans laquelle le fil présente un diamètre moyen inférieur à environ 2 mm, éventuellement dans laquelle le fil présente un diamètre moyen inférieur à environ 1 mm.

3. Structure selon la revendication 1 ou 2, dans laquelle le matériau élastomère est un composite élastomère.

4. Structure selon l'une quelconque des revendications 1 à 3, dans laquelle le matériau élastomère est un composite élastomère à base de sulfure de zinc dopé au cuivre (ZnS :Cu).

5. Structure selon la revendication 4, dans laquelle le composite élastomère à base de ZnS :Cu est un composite ZnS :Cu/polydiméthylsiloxane, éventuellement dans laquelle le composite ZnS :Cu/polydiméthylsiloxane contient environ de 5 % à environ 70 % en masse de ZnS :Cu.

6. Structure selon l'une quelconque des revendications 1 à 5, dans laquelle le matériau mécano-optoélectronique est un composite mécano-luminescent-optoélectronique.

7. Structure selon l'une quelconque des revendications 1 à 6, dans laquelle le matériau mécano-optoélectronique est un film.

8. Structure selon l'une quelconque des revendications 1 à 7, dans laquelle le matériau mécano-optoélectronique est un film de poly(3-hexylthiophène).

9. Structure selon la revendication 8, dans laquelle le film de poly(3-hexylthiophène) est un film d'ester méthylique de l'acide poly(3-hexylthiophène):phényl-C61-butyrique, éventuellement dans laquelle le film d'ester méthylique de l'acide poly(3-hexylthiophène):phényl-C61-butyrique comprend un rapport massique 1:1 du poly(3-hexylthiophène) à l'ester méthylique de l'acide phényl-C61-butyrique.

10. Structure selon la revendication 8, dans laquelle le film de poly(3-hexylthiophène) est dopé avec des nanotubes de carbone.

11. Structure selon l'une quelconque des revendications 1 à 10, dans laquelle le matériau mécano-optoélectronique produit un courant continu en réponse à une force mécanique qui est exercée sur le fil, éventuellement dans laquelle la force mécanique est une force vibratoire ou une contrainte.

12. Structure selon l'une quelconque des revendications 1 à 11, comprenant en outre une couche de fibres entourant la structure, éventuellement dans laquelle la couche de fibres comprend une fibre naturelle, une fibre synthétique, du coton, du polyester, de la rayonne, ou du nylon.

13. Structure selon l'une quelconque des revendications 1 à 12, dans laquelle la structure est torsadée avec un filament, éventuellement dans laquelle la structure et le filament sont torsadés avec une torsion en S ou une torsion en Z.

14. Structure selon l'une quelconque des revendications 1 à 13, dans laquelle la structure comprend en outre une électrode intégrée dans la structure, éventuellement dans laquelle l'électrode collecte un courant continu.

15. Structure selon l'une quelconque des revendications 1 à 14, dans laquelle le fil présente une élasticité d'au moins environ 80 %, éventuellement dans laquelle le fil présente une élasticité d'au moins environ 95 %.
